# EUROPÄISCHE PATENTSCHRIFT

(11) **EP 0 319 870 B1**
(45) Veröffentlichungstag und Bekanntmachung des Hinweises auf die Patenterteilung: **27.01.1993**
(21) Anmeldenummer: 88120203.0
(22) Anmeldetag: 03.12.1988
(51) Int. Cl.: H03K 17/73, H03K 17/08

(54) **Verfahren zum Schutz der Gate-Unit für einen GTO-Thyristor**
Method for protecting the gate unit of a GTO thyristor
Procédé pour la protection du module de gâchette d'un thyristor blocable

(30) Priorität: 09.12.1987 DE 3741713
(43) Veröffentlichungstag der Anmeldung: 14.06.1989
(73) Patentinhaber: BBC Brown Boveri AG, CH-5401 Baden (CH)
(72) Erfinder: Peppel, Michael, Dr., D-6940 Weinheim (DE)
(74) Vertreter: Rupprecht, Klaus, Dipl.-Ing.

(56) Entgegenhaltungen:
- EP-A- 0 107 137
- US-A- 4 429 339
- ELEKTRONIK, Band 31, Nr. 1, Januar 1982, Seite 71, Muenchen, DE; R. OESTERHAUS: "Ansteuerung von Leistungs-Feldeffekttransistoren über Optokoppler
- ELEKTRONIK, Band 21, 19. Oktober 1984, Seiten 91-96; A. HONDA: "Optimierte Ansteuerschaltungen für GTO-Thyristoren (2. Teil)"
- SIEMENS COMPONENTS, Band XXII, Nr. 1, Februar 1987, Seiten 24-26, Berlin und München, DE; M. BECHTELER: "GTO thyristors-power switches for today and tomorrow"

## Beschreibung

Die Erfindung bezieht sich auf ein Verfahren zum Schutz der Gate-Unit für einen GTO-Thyristor gemäß dem Oberbegriff des Anspruchs 1.

Es ist z.B. aus IEEE Transactions on Industrial Electronics, Vol. IE-32, No.3, Aug. 1985, Seite 204 bekannt, daß zur Ansteuerung eines GTO-Thyristors eine spezielle Ansteuereinheit - die Gate-Unit - benötigt wird, die dem GTO-Thyristor über seinen Gate-Anschluß die zum Ein- und Abschalten notwendigen Ströme zuführt. Der Ausschaltteil einer Gate-Unit besteht aus einer leistungsstarken Spannungsquelle, die zur Erzeugung von negativen Löschimpulsen über einen aus mehreren parallelen Feldeffekttransistoren gebildeten steuerbaren elektronischen Schalter an die Ausgangsklemmen der Gate-Unit geschaltet wird. Besteht am Ausgang der Gate-Unit ein Kurzschluß oder ist der angeschlossene GTO-Thyristor defekt, so können die dann auftretenden Überströme die Feldeffekttransistoren des elektronischen Schalters zerstören.

Bei einem Klemmenkurzschluß der Gate-Unit tritt ein hoher, über dem betrieblichen Maximalwert liegender Überstrom auf, der in kurzer Zeit die Feldeffekttransistoren zerstört. Bei einem Defekt des GTO-Thyristors treten im allgemeinen zwar nur Fehlerströme in Höhe der regulären GTO-Löschimpulse oder darunter auf. Da diese Fehlerströme jedoch wesentlich länger fließen als es der maximalen Dauer der Löschimpulse entspricht, sind die Feldeffekttransistoren auch in diesem Fall gefährdet.

Der Erfindung liegt hiervon ausgehend die Aufgabe zugrunde, ein Verfahren zum Schutz der Gate-Unit für einen GTO-Thyristor der eingangs genannten Art anzugeben, welches den zum Ausschalten des GTO-Thyristors dienenden steuerbaren elektronischen Schalter sowohl bei Auftreten eines Klemmenkurzschlusses als auch bei einem Defekt des GTO-Thyristors zuverlässig schützt.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile liegen insbesondere darin, daß das Verfahren wenig Aufwand und Kosten erfordert. Beide unterschiedlichen Fehler (Klemmenkurzschluß, GTO-Thyristor-Defekt) werden sicher beherrscht. Dabei ist es möglich, sowohl die kurzzeitig mögliche maximale Belastbarkeit als auch die Dauerbelastbarkeit des steuerbaren elektronischen Schalters voll auszuschöpfen.

Die Erfindung wird nachstehend anhand der in der Zeichnung dargestellten Ausführungsbeispiele erläutert.

Es zeigen:
- Fig. 1: das Ausgangskennlinienfeld eines Leistungs-Feldeffekttransistors,
- Fig. 2: eine Prinzipschaltung für den Schutz eines Feldeffekttransistors,
- Fig. 3: Strom- und Spannungsverläufe bei einem Feldeffekttransistor und die Kennlinie der Auswerteeinrichtung,
- Fig. 4: ein detailliertes Ausführungsbeispiel für den Schutz einer Ansteuereinheit.

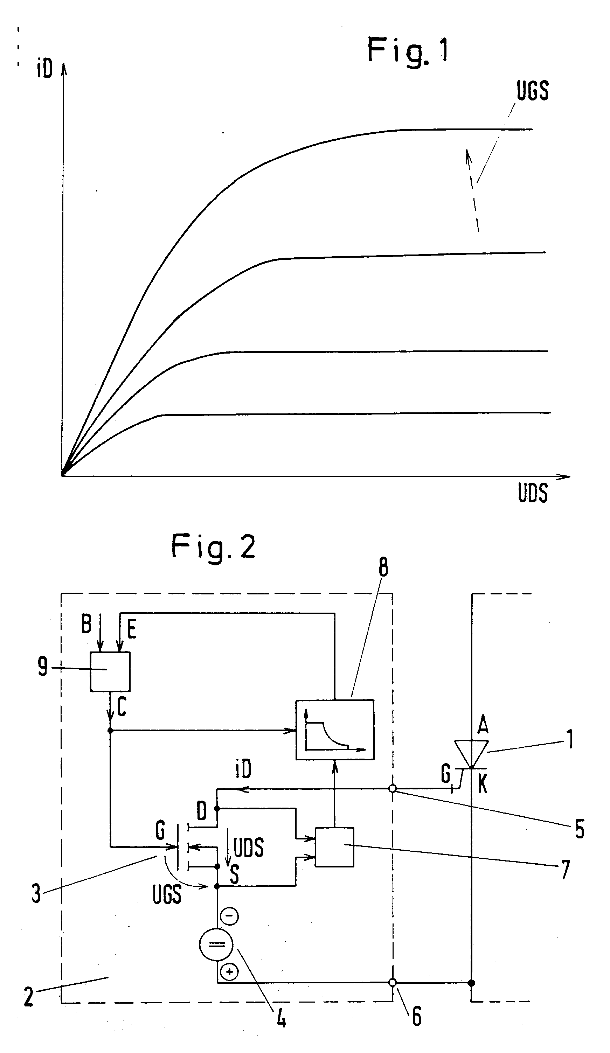

In Fig. 1 ist das Ausgangskennlinienfeld eines Leistungs-Feldeffekttransistors (MOS-FET) dargestellt (UDS bis ca. 10V, iD bis ca. 200A, UGS bis ca. 17V, Einzelimpulse einer Impulsdauer von ca. 7Sµs). Es ist die Abhängigkeit des Drain-Stromes iD durch den Feldeffekttransistor von der Drain-Source-Spannung UDS am Feldeffekttransistor gezeigt, wobei die Gate-Source-Spannung UGS (Steuerspannung) am Feldeffekttransistor als Parameter dient. Das Kennlinienfeld zeigt, daß auch Leistungs-MOS-FETS bei höchster Aussteuerung noch das typische Verhalten üblicher Feldeffekttransistoren zeigen. Bei relativ niedriger Drain-Source-Spannung UDS verhält sich der Feldeffekttransistor wie ein ohmscher Widerstand mit stromproportionalem Spannungsabfall. Bei relativ hoher Drain-Source-Spannung ("Abschnürbereich") verhält sich der Feldeffekttransistor dagegen wie eine Stromquelle, d.h. der Drain-Strom iD ist unabhängig von der Drain-Source-Spannung UDS. Zwischen beiden Verhaltensweisen existiert ein breites Übergangsgebiet.

Das aus dem Kennlinienfeld ersichtliche Verhalten zeigt für das nachstehend beschriebene Schutzverfahren wichtige Aspekte auf. Es ist zum einen ersichtlich, daß bei Kenntnis der Drain-Source-Spannung UDS des Feldeffekttransistors auf den fließenden Drain-Strom iD geschlossen werden kann, sofern die Steuerspannung UGS bekannt ist. Ferner ist zu erkennen, daß der Drain-Strom iD ab einer bestimmten UDS-Schwelle einen vom Feldeffekttransistor selbst gegebenen Maximalwert nicht überschreitet. Schließlich zeigt die Erfahrung, daß der Feldeffekttransistor den Betrieb bei diesem Maximalstrom einige Mikrosekunden lang (Impulsdauer) schadlos übersteht.

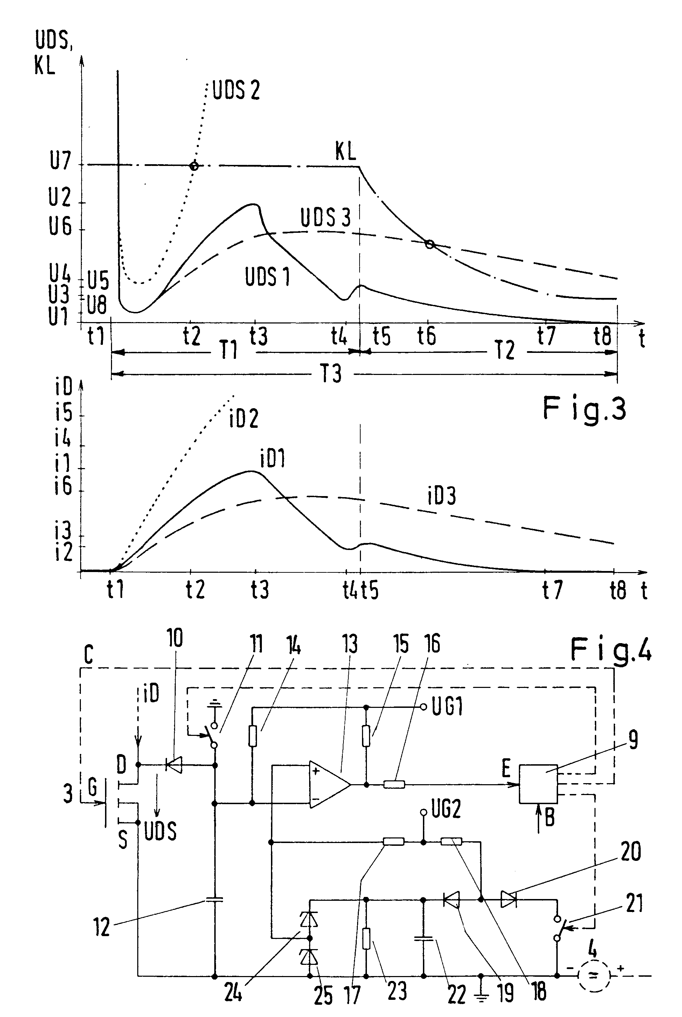

Das Schutzverfahren nutzt diese vorgenannten Eigenschaften des Feldeffekttransistors gezielt aus. Als Indikator für eine durch Überstrom verursachte Überlastung des Feldeffekttransistors wird die Drain-Source-Spannung UDS am Transistor herangezogen. Diese Drain-Source-Spannung UDS wird mit einem vorgegebnen Schwellwert einer Kennlinie (KL, siehe Fig. 3) verglichen. Überschreitet UDS den Schwellwert der Kennlinie, so wird der Feldeffekttransistor zwangsweise gesperrt und damit der Überstrom (Fehlerstrom) unterbrochen. Die Kennlinie ist eine an den im ungestörten Betrieb zu erwartenden Stromverlauf des Feldeffekttransistors unter Beachtung der jeweils möglichen Belastbarkeit angepaßte Zeitfunktion.

In Fig. 2 ist zur weiteren Erläuterung des Schutzverfahrens eine Prinzipschaltung für den Schutz eines Feldeffekttransistors dargestellt. Es ist ein GTO-Thyristor 1 mit Anode A, Kathode K und Gate G zu erkennen. Die Ansteuerung (Ein- und Ausschalten) des GTO-Thyristors 1 erfolgt durch eine Gate-Unit (Ansteuereinheit) 2. Diese Gate-Unit 2 weist zum Abschalten des GTO-Thyristors 1 einen Feldeffekttransistor 3 mit Drain D, Source S und Gate G auf. Üblicherweise sind mehrere Leistungs-MOS-FET parallelgeschaltet und gesteuert, es wird jedoch nachfolgend lediglich ein Feldeffekttransistor betrachtet.

Source S ist an den negativen Pol einer Gleichspannungsquelle 4 angeschlossen. Drain D liegt über eine Ausgangsklemme 5 der Gate-Unit 2 am Gate G des GTO-Thyristors. Der in Drain D fließende Strom ist mit iD bezeichnet. Der positive Pol der Gleichspannungsquelle 4 ist über eine weitere Ausgangsklemmen 6 der Gate-Unit 2 mit der Kathode K des GTO-Thyristors 1 verbunden. Eine Spannungserfassungseinrichtung 7 erfaßt die zwischen Drain D und Source S anstehende Spannung UDS und meldet diese einer Auswertevorrichtung 8. Gate G wird von einer Steuereinrichtung 9 mit Steuersignalen C beaufschlagt. Diese Steuersignale C werden ebenfalls der Auswerteeinrichtung 8 zugeführt. Der Steuereinrichtung 9 liegen eingangsseitig Befehle B (Sperrbefehl/Leitbefehl) sowie gegebenenfalls Sperrbefehle E der Auswerteeinrichtung 8 an.

Die Auswerteeinrichtung vergleicht bei Vorliegen eines Steuersignales C die erfaßte Spannung UDS mit einer vorgegebenen Kennlinie (KL, siehe Fig. 3, Vergleichsspannung, Zeitfunktion). Überschreitet die Drain-Source-Spannung den Schwellwert der vorgegebenen Kennlinie, so gibt die Auswerteeinrichtung 8 einen Sperrbefehl E an die Steuereinrichtung 9, um den Stromfluß durch den Feldeffekttransistor 3 zu unterbrechen. Auf diese Weise wird der Feldeffekttransistor 3 vor einer Zerstörung infolge eines Überstromes (Fehlerstrom) geschützt. Bleibt die erfaßte Drain-Source-Spannung im gesamten, von der Auswertevorrichtung überwachten Zeitbereich unterhalb des Schwellwerts der Kennlinie, so erfolgt keine Reaktion seitens der Auswertevorrichtung 8. Bei gesperrtem Feldeffekttransistor 3 (es liegt kein Steuersignal C vor) wird die Auswerteeinrichtung 8 ausgeschaltet.

In Fig. 3 sind zur weiteren Erläuterung der Auswerteeinrichtung 8 die Strom- und Spannungsverläufe bei einem Feldeffekttransistor und die Kennlinie der Auswerteeinrichtung dargestellt. Im einzelnen sind im oberen Bild der Fig. 3 die zeitlichen Verläufe der Drain-Source-Spannungen UDS1 (durchgezogener Linienzug), UDS2 (gepunkteter Linienzug), UDS3 (gestrichelter Linienzug) und der Kennlinie KL der Auswerteeinrichtung 8 (strichpunktierter Linienzug) gezeigt. Im unteren Bild der Fig. 3 sind die zeitlichen Verläufe der Drain-Ströme iD1 (durchgezogener Linienzug), iD2 (gepunkteter Linienzug) und iD3 (gestrichelter Linienzug) dargestellt.

Die Drain-Source-Spannung UDS1 und der Drain-Strom iD1 entsprechen dem ungestörten Betrieb des Feldeffekttransistors 3. Zum Zeitpunkt t1 wird die Einschaltung des Feldeffekttransistors 3 durch ein Steuersignal C (siehe Fig. 2) eingeleitet. Die Drain-Source-Spannung UDS1 sinkt kurz nach t1 auf einen ersten Minimalwert U1 ab, erreicht anschließend zum Zeitpunkt t3 einen ersten Spitzenwert U2, fällt danach auf einen zweiten Minimalwert U3 zum Zeitpunkt t4 ab, steigt anschließend auf einen zweiten Spitzenwert U4 zum Zeitpunkt t5 und fällt schließlich exponentiell bis auf den Wert 0 zum Zeitpunkt t7 ab. Der Drain-Strom iD1 steigt bis zum Zeitpunkt t3 auf einen ersten Spitzenwert, fällt zum Zeitpunkt t4 auf einen ersten Minimalwert i2 ab, steigt zum Zeitpunkt t5 auf einen zweiten Spitzenwert i3 ("Schweifstrom") und fällt schließlich exponentiell bis auf den Wert 0 zum Zeitpunkt t7 ab.

Die Drain-Source-Spannung UDS2 und der Drain-Strom iD2 entsprechen einem Betrieb des Feldeffekttransistors 3 bei einem Klemmenkurzschluß zwischen den beiden Ausgangsklemmen 5, 6 der Gate- Unit 2. Die Drain-Source-Spannung UDS2 sinkt kurz nach t1 auf einen Minimalwert U5 und steigt anschließend steil nach oben. Zum Zeitpunkt t2 tritt ein Schnittpunkt zwischen UDS2 und dem Schwellwert der Kennlinie KL auf. Der Drain-Strom iD2 steigt ab t1 steil nach oben und erreicht zum Zeitpunkt t2 (= Zeitpunkt, bei dem die zwangsweise Abschaltung des Feldeffekttransistors durch die Auswertevorrichtung 8 eingeleitet wird) den Abschaltwert i4. Der vom Feldeffekttransistor ohne Zerstörung kurzzeitig führbare Maximalwert des Drain-Stromes ist mit iD5 bezeichnet. Der vorstehend erwähnte Abschaltwert i4 des Drain-Stromes darf selbstverständlich den Maximalwert i5 nicht erreichen bzw. überschreiten.

Die Drain-Source-Spannung UDS3 und der Drain-Strom iD3 entsprechen einem Betrieb des Feldeffekttransistors 3 bei einem defekten GTO-Thyristor 1. Die Drain-Source-Spannung UDS3 sinkt wie beim ungestörten Betrieb kurz nach t1 auf einen Minimalwert U1, steigt anschließend langsam auf einen Spitzenwert U6 im Zeitraum zwischen t3 und t4 und fällt danach relativ langsam ab. Der Spitzenwert U6 ist geringfügig kleiner als der Spitzenwert U2 bei ungestörtem Betrieb. Im betrachteten Zeitraum erreicht UDS3 nicht den Wert 0. Zum Zeitpunkt t6 tritt ein Schnittpunkt zwischen UDS3 und dem Schwellwert der Kennlinie KL auf. Der Drain-Strom iD3 steigt ab t1 langsam auf einen Spitzenwert i6 im Zeitraum zwischen t3 und t4 und fällt danach langsam ab. Der Spitzenwert i6 ist geringfügig kleiner als der Spitzenwert i1 bei ungestörtem Betrieb. Im betrachteten Zeitraum erreicht iD3 nicht den Wert 0.

Bei zusammenfassender Betrachtung der Strom- und Spannungsverläufe bei ungestörtem Betrieb sowie bei Auftreten der Fehler "Klemmenkurzschluß" und "defekter GTO-Thyristor" ist festzustellen, daß beim Fehler "Klemmenkurzschluß" im Feldeffekttransistor ein hoher, über dem Maximalwert i5 liegender Überstrom (siehe iD2) zusammen mit einem hohen Spannungsabfall an der Drain-Source-Strecke des Feldeffekttransistors (siehe UDS2) auftritt. Der Feldeffekttransistor wird dabei in kurzer Zeit zerstört. Beim Fehler "defekter GTO-Thyristor" treten im allgemeinen nur Fehlerströme (siehe iD3) in Höhe der regulären Drain-Ströme (siehe iD1) oder darunter auf. Da diese Fehlerströme (siehe iD3) aber wesentlich länger fließen als es der maximalen Dauer der kurzzeitigen Löschimpulse (siehe iD1) entspricht, tritt auch bei diesem Fehler eine Gefährdung des Feldeffekttransistors auf.

Die Kennlinie KL der Auswerteeinrichtung 8 ist so auszubilden, daß der Feldeffekttransistor bei beiden gefährlichen Fehlern zuverlässig geschützt wird. Hierzu weist die Kennlinie KL in einem ersten Zeitintervall T1 einen Schwellwert U7 auf, der so bemessen ist, daß er bei ungestörtem Betrieb des Feldeffekttransistors 3 (regulärer Löschstrom des GTO-Thyristor, kein Klemmenkurzschluß, kein defekter GTO-Thyristor) von der Drain-Source-Spannung (UDS1) niemals erreicht, bei einem Klemmenkurzschluß an der Gate-Unit 2 jedoch überschritten wird (UDS2). Die Dauer des Zeitintervalls T1 ist so bemessen, daß der Löschstrom des GTO-Thyristors auch unter "worst case"-Bedingungen im wesentlichen abgeklungen ist. Nach Ablauf von T1 wird der Schwellwert der Kennlinie KL während eines zweiten Zeitintervalls T2 in zeitlicher Abhängigkeit bis auf einen Wert U8 soweit erniedrigt, daß nur noch die zulässige Dauerbelastung des Feldeffekttransistors berücksichtigt wird. Dies ist deshalb möglich, weil der Feldeffekttransistor in diesem zweiten Zeitintervall bei ungestörtem Betrieb nur noch einen sehr kleinen Drain-Strom (iD1) führt. Der Schwellwert U8 der Kennlinie im zweiten Zeitintervall T2 ist so zu bemessen, daß die Auswerteeinrichtung 8 nicht durch den normalen, über den Feldeffekttransistor fließenden "Schweifstrom" des GTO-Transistors (siehe UDS1 bzw. iD1 im Zeitraum zwischen t4 und t7) aktiviert wird. Die Dauer des Zeitintervalls T2 muß so lange sein, daß der Drain-Strom (siehe iD1) bei ungestörtem Betrieb sicher abgeklungen ist. Gemäß Fig. 3 endet die Kennlinie KL zum Zeitpunkt t8. Da die Drain-Source-Spannung UDS3 bei defektem GTO-Thyristor gegenüber der Spannung UDS1 bei ungestörtem Betrieb im Zeitintervall T2 erhöht ist, führt dies zu einem Überschreiten der Kennlinie KL der Auswerteeinheit 8.

In Fig. 4 ist ein detailliertes Ausführungsbeispiel für den Schutz einer Ansteuereinheit 2 dargestellt. Im einzelnen ist zu erkennen, daß die Kathode einer Diode 10 an Drain D des Feldeffekttransistors 3 angeschlossen ist. Die Anode der Diode 10 ist über einen steuerbaren elektronischen Schalter 11 mit Masse verbindbar. Der Schalter 11 wird durch die Steuereinrichtung 9 angesteuert. Gleichzeitig liegt die Anode der Diode 10 über einem Kondensator 12 an Source des FET 3, am negativen Eingang eines Komparators 13 und über einen Widerstand 14 an einer positiven Gleichspannung UG1. Ein Widerstand 15 ist zwischen Gleichspannung UG1 und Ausgang des Komparators 13 geschaltet. Ein weiterer Widerstand 16 liegt zwischen dem Ausgang des Komparators 13 und der Steuereinrichtung 9 für den FET.

Der positive Eingang des Komparators 13 ist über einen Widerstand 17 mit einer positiven Gleichspannung UG2 verbunden und über einen in Serie zum Widerstand 17 geschalteten Widerstand 18 an den gemeinsamen Verbindungspunkt der Anoden zweier Dioden 19, 20 angeschlossen. Die Kathode der Diode 20 ist über einen steuerbaren elektronischen Schalter 21 mit Masse verbindbar. Der Schalter 21 wird durch die Steuereinrichtung 9 angesteuert. Die Kathode der Diode 19 liegt über einen Kondensator 22 sowie über einen parallen Widerstand 23 an Masse und ist an die Kathode einer Zenerdiode 24 angeschlossen. Die Anode der Zenerdiode 24 ist an den Verbindungspunkt des Widerstandes 17 und des positiven Komparator-Einganges geschaltet und liegt über der Kathoden-Anoden-Strecke einer weiteren Zenerdiode 25 an Masse. Der negative Pol der Gleichspannungsquelle 4 ist ebenfalls mit Masse verbunden.

Zur Erläuterung der Funktionsweise der Schaltung gemäß Fig. 4 ist davon auszugehen, daß die Drain-Source-Spannung UDS am Feldeffekttransistor 3 dem negativen Eingang des Komparators 13 über die aus Diode 10 und Widerstand 14 bestehende "Klemmschaltung" zugeführt wird. Damit die im ausgeschalteten Zustand des Feldeffekttransistors 3 auftretende relativ hohe Spannung UDS vom Komparator 13 nicht fälschlich als extrem hoher Überstrom interpretiert wird, schaltet der elektronische Schalter 11 den negativen Komparator-Eingang auf Masse, sobald sich der Feldeffekttransistor 3 im Sperrzustand befindet, d.h. der elektronische Schalter 11 ist geschlossen, wenn der FET sperrt und geöffnet, wenn der FET leitet. Dies entspricht dem unter Fig. 2 erwähnten Abschalten der Auswerteeinrichtung 8 in Abhängigkeit der Steuersignale C.

Die am positiven Eingang des Komparators 13 anstehende Vergleichspannung (= Kennlinie KL) wird nach einer Zeitfunktion "gefahren", damit einerseits die hohen Gate-Stromspitzen des GTO-Thyristors 1 (siehe iD1, i1, UDS1, U2 in Fig. 3) den Schutz nicht auslösen, andererseits jedoch auch relativ niedrige, aber lang anhaltende Fehlerströme (siehe iD3, UDS3 in Fig. 3) zur Auslösung führen. Der Vergleichsspannungsgeber besteht aus den Widerständen 17, 18, 23, dem Kondensator 22, dem Schalter 21, den Dioden 19, 20, den Zenerdioden 24, 25 und der Gleichspannung UG2.

Unmittelbar nach dem Einschalten des Feldeffekttransistors 3 ist der Schwellwert der Kennlinie KL (= Vergleichspegel) zunächst U7 (z.B. U7 = 3V, siehe Fig. 3). Bei diesem Schwellwert kann ein üblicherweise eingesetzter Leistungs-MOS-FET beispielsweise 100A Drain-Strom führen. Dies reicht bei Parallelschaltung mehrerer Leistungs-MOS-FETs zur Erzeugung eines GTO-Abschaltimpulses aus. Nach einem Zeitintervall T1 von beispielsweise 40µs wird der Schwellwert der Kennlinie KL exponentiell auf U8 (z.B. U8 = 1,5V) "heruntergefahren". Beim Schwellwert U8 ist ein Dauerbetrieb der Leistungs-MOS-FETs zulässig.

Der Vergleichsspannungsgeber funktioniert folgendermaßen: Wenn der Feldeffekttransistor 3 sperrt (GTO-Thyristor 1 leitet), ist der Schalter 21 geöffnet, wenn der Feldeffekttransistor leitet, ist der Schalter 21 geschlossen. Bei sperrendem FET 3 und geöffnetem Schalter 21 fließt ein Strom von UGS2 über Widerstand 18, Diode 19 und die in Sperrichtung betriebenen Zenerdioden 24 und 25 nach Masse ab. Die am positiven Eingang des Komparators 13 anstehende Vergleichsspannung (= Kennlinie KL) weist ihren durch die Zenerdiode 25 bestimmten "Startwert" U7 auf. Der Kondensator 22 ist auf eine durch die Zenerdioden 24, 25 bestimmte Spannung aufgeladen. Zum Zeitpunkt t1 wird der Feldeffekttransistor 3 eingeschaltet. Gleichzeitig wird der Schalter 21 geschlossen. Hierdurch wird die Anode der Diode 19 über die Diode 20 an Masse gelegt (die Schaltung kann gegebenenfalls auch so ausgebildet sein, daß durch den Schalter 21 selbst der Feldeffekttransistor 3 eingeschaltet und zugleich die Anode der Diode 19 an Masse gelegt wird). Hierdurch sperren sofort die Diode 19 und die Zenerdiode 24. Die am positiven Eingang des Komparators 13 anstehende Vergleichsspannung (= Kennlinie KL) wird im Zeitintervall t1 über den Widerstand 17 und die Zenerdiode 25 "gehalten" und beträgt nach wie vor U7. Der Kondensator 22 entlädt sich - vom restlichen Vergleichsspannungsgeber völlig entkoppelt - über den Widerstand 23. Ab einem gewissen Wert der Kondensatorspannung an22 wird die Zenerdiode 24 in Flußrichtung leitend. Dies entspricht dem Zeitpunkt t5 gemäß Fig. 3. Ab t5 folgt die am positiven Eingang des Komparators 13 anstehende Vergleichsspannung (= Kennlinie KL) über die leitende Zenerdiode 24 der Kondensatorspannung an22, wobei sich der Kondensator 22 nach wie vor über den Widerstand 23 entlädt. Dies entspricht dem Zeitintervall T2 gemäß Fig. 3.

In diesem Intervall nimmt die Vergleichsspannung des Komparators 13 nach Maßgabe der resultierenden RC-Zeitkonstante der Elemente 17, 22 und 23 exponentiell ab, bis sie ihren Endwert (U8) erreicht hat. U8 ergibt sich aus der Teilung der Spannung UG2 durch die Widerstände 17 und 23 unter Berücksichtigung der Flußspannung der Diode 24.

## Patentansprüche

1. Verfahren zum Schutz der Gate-Unit (2) für einen GTO-Thyristor (1), bei der ein steuerbarer elektronischer Schalter (3) zum Ausschalten des GTO-Thyristors (1) mittels eines Löschimpulses dient, wobei die am steuerbaren elektronischen Schalter (3) abfallende Spannung erfaßt und mit einer vorgegebenen Kennlinie (KL) verglichen wird, dadurch gekennzeichnet, daß die Kennlinie (KL) eine Zeitfunktion ist, welche sowohl an die kurzzeitig mögliche maximale Belastbarkeit beim Einschalten, als auch an die Dauerbelastbarkeit des elektronischen Schalters (3) angepaßt ist, und daß der elektronische Schalter (3) gesperrt wird, sobald die erfaßte Spannung (UDS) die vorgegebene Kennlinie (KL) überschreitet.

2. Verfahren nach Anspruch 1, dadurch gekennzeichnet, daß die Kennlinie (KL) so bemessen ist, daß ihr Schwellwert während eines ersten Zeitintervalles (T1) unmittelbar nach dem Einschalten des elektronischen Schalters (3) konstant ist (U7) und durch einen regulären Löschimpuls (UDS1) niemals erreicht, jedoch bei einem Klemmenkurzschluß (UDS2) am Ausgang der Gate-Unit (2) überschritten wird.

3. Verfahren nach Anspruch 2, dadurch gekennzeichnet, daß die Kennlinie (KL) so bemessen ist, daß ihr Schwellwert während eines sich an das erste Zeitintervall (T1) anschließenden zweiten Zeitintervalles (T2) vom konstanten Wert (U7) auf einen niedrigeren Wert (U8) abgesenkt wird, wobei der niedrigere Wert (U8) an der zulässigen Dauerbelastung des elektronischen Schalters (3) bemessen ist.

4. Verfahren nach Anspruch 3, dadurch gekennzeichnet, daß der Schwellwert der Kennlinie im zweiten Zeitintervall (T2) exponentiell abgesenkt wird.

5. Verfahren nach einem der Ansprüche 1 bis 4, dadurch gekennzeichnet, daß bei gesperrtem elektronischen Schalter (3) die am Schalter abfallende Spannung (UDS) nicht erfaßt wird.

## Claims

1. Method for protection of a gate unit (2) for a GTO thyristor (1), in which a controllable electronic switch (3) is used for switching off the GTO thyristor (1) by means of a turn-off pulse, the voltage dropped across the controllable electronic switch (3) being detected and compared with a predetermined characteristic (KL), characterised in that the characteristic (KL) is a time function which is matched both to the short-term maximum possible load capability on switching on and to the continuous load capability of the electronic switch (3), and in that the electronic switch (3) is switched off as soon as the detected voltage (UDS) exceeds the predetermined characteristic (KL).

2. Method according to Claim 1, characterised in that the characteristic (KL) is dimensioned such that its threshold value is constant (U7) during a first time interval (T1) directly after the electronic switch (3) is switched on and is never reached by a regular turn-off pulse (UDS1), but is exceeded by a terminal short-circuit (UDS2) at the output of the gate unit (2).

3. Method according to Claim 2, characterised in that the characteristic (KL) is dimensioned such that its threshold value is reduced from the constant value (U7) to a lower value (U8) during a second time interval (T2) following the first time interval, the lower value (U8) being dimensioned to the permissible continuous load of the electronic switch (3).

4. Method according to Claim 3, characterised in that the threshold value of the characteristic is reduced exponentially in the second time interval (T2).

5. Method according to one of Claims 1 to 4, characterised in that the voltage (UDS) dropped across the switch is not detected when the electronic switch (3) is switched off.

## Revendications

1. Procédé de protection de l'ensemble gâchette (2) d'un thyristor GTO dans lequel on utilise un commutateur (3) électronique commandé pour rendre bloquant le thyristor GTO (1) au moyen d'une impulsion de coupure, la tension aux bornes du commutateur (3) électronique étant mesurée et comparée à une courbe caractéristique prédéterminée (KL), caractérisé par le fait que la courbe caractéristique (KL) est une fonction du temps qui est adaptée à la fois à la charge maximale admissible pour une courte durée lors de la commutation et à la charge admissible en continu du commutateur électronique (3) et par le fait que le commutateur (3) électronique est bloqué dès que la tension (UDS) mesurée dépasse la courbe caractéristique (KL) prédéterminée.

2. Procédé selon la revendication 1, caractérisé par le fait que la courbe caractéristique (KL) est telle que, pendant un premier intervalle de temps (T1) situé juste après la commutation à l'état passant du commutateur (3) électronique, son seuil est constant (U7) et n'est jamais atteint par une impulsion de coupure (UDS1) normale tandis qu'il est dépassé en cas de court-circuit (UDS2) des bornes à la sortie de l'ensemble gâchette (2).

3. Procédé selon la revendication 2, caractérisé par le fait que la courbe caractéristique (KL) est telle que, pendant un deuxième intervalle de temps (T2) venant immédiatement à la suite du premier intervalle de temps (T1), son seuil est abaissé de la valeur constante (U7) à une valeur plus faible (U8), la valeur plus faible (U8) étant adaptée à la charge admissible en continu du commutateur électronique (3).

4. Procédé selon la revendication 3, caractérisé par le fait que la valeur de seuil de la courbe caractéristique est abaissée de manière exponentielle pendant le deuxième intervalle de temps (T2).

5. Procédé selon l'une des revendications 1 à 4, caractérisé par le fait que la tension (UDS) aux bornes du commutateur n'est pas mesurée lorsque le commutateur électronique (3) est commuté à l'état bloquant.
